# EUROPEAN PATENT SPECIFICATION

(11) **EP 2 418 257 B1**
(45) Date of publication and mention of the grant of the patent: **18.12.2013**
(21) Application number: 11181281.4
(22) Date of filing: 20.05.2008
(51) Int. Cl.: C09B 49/00, C09B 49/12, H01G 9/20, H01L 51/00, C09B 23/10

(54) **Novel organic dye and method of preparing the same**
Neuer organischer Farbstoff und sein Herstellungsverfahren
Nouveau colorant organique et son procédé de préparation

(30) Priority: 28.05.2007 KR 20070051619
(43) Date of publication of application: 15.02.2012
(62) Divisional of application: 08753600.9
(73) Proprietor: Dongjin Semichem Co., Ltd., Seo-gu, Incheon 404-205 (KR)
(72) Inventor: Ko, Jae-jung, 339-700 Chungcheongnam-do (KR); Bae, Ho-gi, 445-781 Gyeonggi-do (KR)
(74) Representative: Bockhorni & Kollegen

(56) References cited:
- KIM D., LEE J. K., KANG S. O., KO J.: "Molecular engineering of organic dyes containing N-aryl carbazole moiety for solar cell", TETRAHEDRON, ELSEVIER SCIENCE PUBLISHERS, AMSTERDAM, NL LNKD- DOI:10.1016/J.TET.2006.12.082, vol. 63, no. 9, 25 January 2007 (2007-01-25), pages 1913-1922, XP005858505, ISSN: 0040-4020
- KOUMURA N., WANG Z.-S., MORI S., MIYASHITA M., SUZUKI E., HARA K.: "Alkyl-Functionalized Organic Dyes for Efficient Molecular Photovoltaics", JOURNAL OF THE AMERICAN CHEMICAL SOCIETY, AMERICAN CHEMICAL SOCIETY LNKD- DOI:10.1021/JA0645640, vol. 128, 8 November 2006 (2006-11-08), pages 14256-14257, XP003018821, ISSN: 0002-7863
- CHOI H., GRÄTZEL M. ET AL: "Highly Efficient and Thermally Stable Organic Sensitizers for Solvent-Free Dye-Sensitized Solar Cells", ANGEWANDTE CHEMIE. INTERNATIONAL EDITION, WILEY VCH VERLAG, WEINHEIM LNKD- DOI:10.1002/ANIE.200454000, vol. 47, no. 2, 16 November 2007 (2007-11-16), pages 327-330, XP002607214, DOI: 10.1002/anie.200703852

## Description

### Technical Field

The present invention relates to an organic dye, and more particularly, to an organic dye which generates a high current, removes instability of an element due to an additive, and sharply improves efficiency of a solar cell with a higher photoelectric conversion efficiency than that of an existing organic dye by introducing a long alkyl chain and preventing π-π stacking without an additive, and a making method thereof.

### Background Art

A solar cell is a cell, an internal semiconductor of which absorbs light and generates an electron and a hole by the photovoltaic effect to thereby generate currents. Conventionally, a semiconductor for a solar cell includes a diode type semiconductor forming an n-p junction with inorganic materials such as silicon or gallium arsenide (GaAs). However, such inorganic semiconductor requires high manufacturing costs while providing good energy conversion efficiency, which is why the application is not wide. To overcome such a problem of the inorganic semiconductor, a technology of replacing the inorganic semiconductor with an organic dye has been suggested.

Typically, a dye has a color by absorbing light mainly in the visible ray band. A solar cell which uses the dye generates a current through a so-called redox reaction in which separated electrons and holes are recombined when the organic dye absorbs light. Such a solar cell is called a dye-sensitized solar cell. After a research team of Michael Gratzel at the Ecole Polytechnique Federale de Lausanne (EPFL) in Switzerland developed a dye-sensitive nano particle titanium dioxide solar cell in 1991, lots of studies have been conducted on the area. Unlike an existing silicon solar cell, the dye-sensitized solar cell is a photoelectrochemical solar cell which includes dye molecules to form electron-hole pairs by absorbing visible rays and transition metal oxide to transfer generated electrons, as main materials.

The dye-sensitized solar cell requires significantly lower manufacturing costs than an existing silicon solar cell does while providing better efficiency, and can possibly replace an existing amorphous silicon solar cell. However, the dye-sensitized solar cell has low energy conversion efficiency and has its own limitation in actual application.

The energy conversion efficiency of the solar cell, i.e., photoelectric conversion ef ficiency is in proportion to the amount of electrons generated by sunlight absorption. To raise the efficiency, the amount of generated electrons may increase with the rise in the sunlight absorption or in absorption amount of the dye, or excited electrons may be prevented from being extinct by electron-hole recombination.

With such reasons, to increase the absorption amount of the dye per unit area, a method of making particles of oxide semiconductor into nano sizes has been developed. To raise absorption of sunlight, methods of raising a reflection rate of platinum electrode or of mixing semiconductor oxide light scatterer in several micrometer sizes have been developed.

Unlike an organic metal dye (Ru dye) of Octahedral structured Gratzel system almost hardly performing π-π stacking between molecules, an organic dye nearly close to a plane as in CHEM. COMMUN. 2003, 252p, and Langmuir, 2004, vol. 20, 4205p, has attraction between molecules. In such intermolecular π-π stacking, LUMO electrons of light absorbing dyes interrupt electrons from easily moving to a TiO₂ conduction band. The untransferred electrons lower efficiency of the cell due to a dark-current leaking to electrolytes. The phenomenon has considerably improved by adding an additive such as DCA (deoxycholoic acid) or TBP (4-tert-butylpyridine). However, the additives reduce the amount of dyes absorbed to TiO₂ surface and lower currents J_{SC}.

Kim et al. disclose in Tetrahedron, Elsevier Science Publishers, Amsterdam, NL, vol. 63, No. 9, 25 January 2007, pages 1913-1922 organic dyes which are used for dye-sensitized solar cells. The organic dyes contain N-(9,9-dimethylfluoren-2-yl)carbazole or N-(4-(2,2-diphenylvinyl)phenyl)carbazole as electron donor and cyanoacrylic or rhodanine-3-acetic acid as electron acceptor bridged by unsubstituted thiophene or vinylene thiophene units.

Koumura et al. describe in the Journal of the American Chemical Society, vol. 128, 8 November 2006, pages 14256-14257 alkyl-functionalized organic dyes for molecular photovoltaics.

### Disclosure of Invention

### Technical Problem

Accordingly, it is an aspect of the present invention to provide an organic dye which generates a high current, removes instability of an element due to an additive and sharply improves efficiency of a solar cell with a higher photoelectric conversion efficiency than that of an existing organic dye by introducing a long alkyl chain and preventing π-π stacking without an additive, and a making method thereof.

Also, it is another aspect of the present invention to provide a dye-sensitized photoelectric conversion element which includes the dye to provide drastically improved photoelectric conversion efficiency, to remove instability of an element due to an additive and to have good J_{sc} (short circuit photocurrent density) and molar extinction coefficient, and a solar cell having improved efficiency.

Additional aspects and/or advantages of the present invention will be set forth in part in the description which follows and, in part, will be obvious from the description, or may be learned by practice of the present invention.

### Technical Solution

The foregoing and/or other aspects of the present invention are also achieved by an organic dye wherein the dye is represented by the following chemical formula 1c-1 or 1c-2.

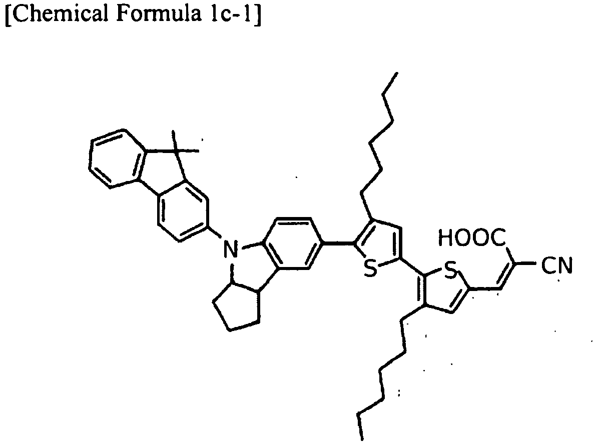

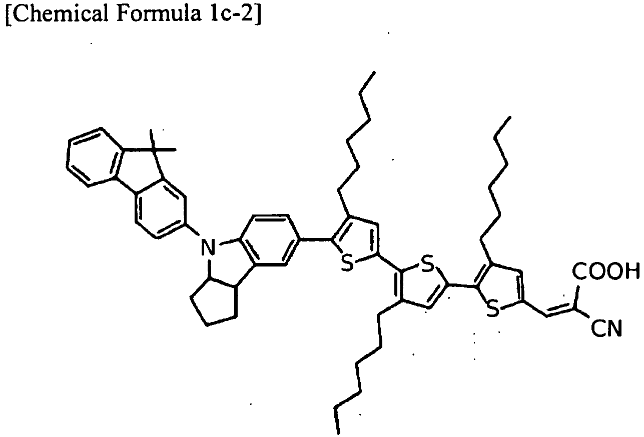

The foregoing and/or other aspects of the present invention are also achieved by providing a making method of an organic dye which is represented by the chemical formula 1c-1 or 1c-2, the making method comprising:
allowing a compound of a following chemical formula 2 to react with a compound of a chemical formula 3 in 1,2-dimethoxyethane to make a compound of a chemical formula 4 below;
allowing the compound of the chemical formula 4 to react with phosphorus oxychloride in dimethylformamide to make a compound of a chemical formula 5 below; and
allowing a compound of a chemical formula 5 to react with cyanoacetate under a presence of piperidine in acetonitrile,

[Chemical Formula 2] **R-Br**

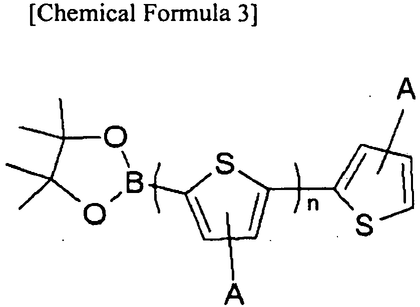

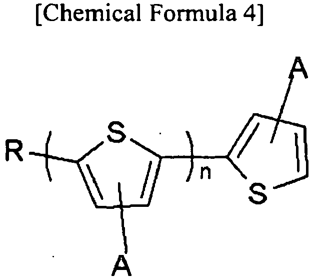

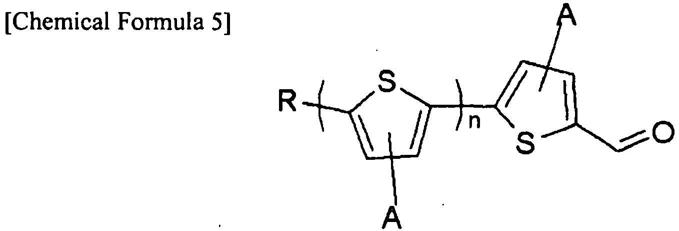

wherein, R refers to 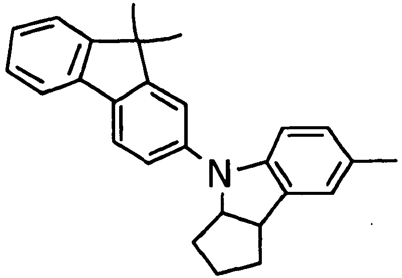 , A is alkyl of C₆ and n is a positive number of 1 or 2.

The compounds of Formula 1c-1 and 1c-2 are special embodiments of an organic dye which is represented by a chemical formula 1 below, 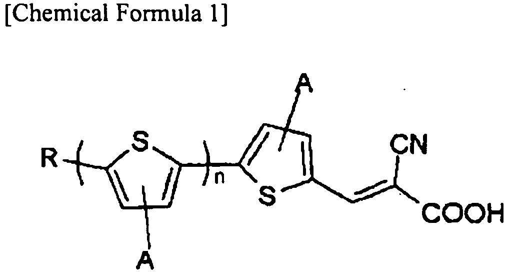 wherein R refers to substituted or unsubstituted 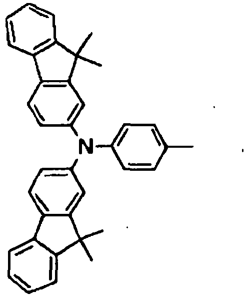 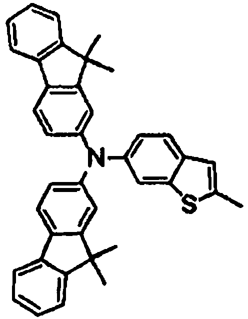 or 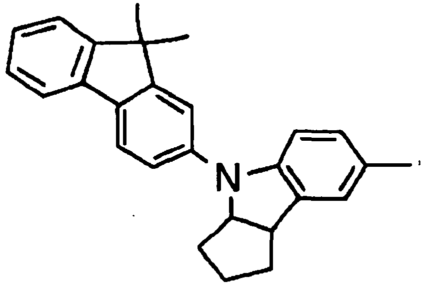 , A is substituted or unsubstituted alkyl of C₁ to C₁₂, individually and n is a positive number of 1 to 4.

A compound of Formula 1 can be made by a making method, the making method comprising allowing a compound of a following chemical formula 2 to react with a compound of a chemical formula 3 in 1,2-dimethoxyethane to make a compound of a chemical formula 4 below; allowing the compound of the chemical formula 4 to react with phosphorus oxychloride in dimethylformamide to make a compound of a chemical formula 5 below; and allowing a compound of a chemical formula 5 to react with cyanoacetate under a presence of piperidine in acetonitrile,

[Chemical Formula 2] **R-Br**

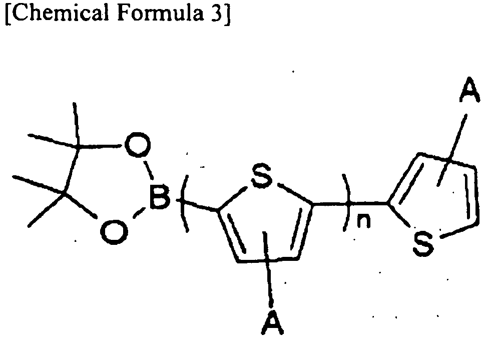

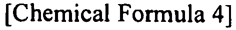

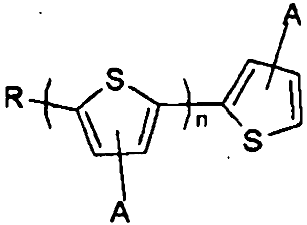

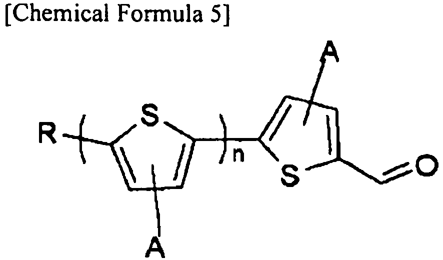

wherein R, A and n are as defined above.

The foregoing and/or other aspects of the present invention are also achieved by providing a dye-sensitized photoelectric conversion element which comprises oxide semiconductor particles carrying the compound represented by the chemical formula 1c-1 and/or 1c-2.

The foregoing and/or other aspects of the present invention are also achieved by providing a dye-sensitized solar cell which comprises the dye-sensitized photoelectric conversion element.

### Advantageous Effects

An organic dye according to the present invention provides better molar extinction coefficient, J_{sc} (short-circuit photocurrent density) and photoelectric conversion efficiency than a conventional metal complex dye to sharply improve efficiency of a solar cell, has a high current and better photoelectric conversion efficiency than an existing organic dye by preventing π - π stacking even without an additive.

### Brief Description of the Drawings

The above and/or other aspects of the present invention will become apparent and more readily appreciated from the following description of the embodiments, taken in conjunction with the accompanying drawings of which:

FIG. 1 is a graph which illustrates currents (J_{sc}) for thicknesses (8µm and 20µm) of 20nm TiO₂ when DCA is added and not added to a compound lb-2; and

FIG. 2 is a graph which illustrates photoelectric conversion efficiency (η) for thicknesses (8µm and 20µm) of 20nm TiO₂ when DCA is added and not added to the compound 1b-2.

### Mode for the Invention

Hereinafter, exemplary embodiments of the present invention will be described with reference to accompanying drawings, wherein like numerals refer to like elements and repetitive descriptions will be avoided as necessary.

Hereinafter, the present invention will be described in detail.

The present inventors have found that a dye-sensitized solar cell has high photoelectric conversion efficiency, J_{sc} (short-circuit photocurrent density) and molar extinction coefficient and provides better efficiency than an existing dye-sensitized solar cell does if made by mixing a compound represented by a chemical formula 1, with oxide semiconductor particles, to prevent π-π stacking by introducing long alkyl chains without an additive.

An organic dye is represented by a following chemical formula 1, and more preferably, has a structure of a following chemical formula 1a-1, 1a-2, 1b-1, 1b-2 (which are not embodiments of the present invention), 1c-1 or lc-2 (which are embodiments of the present invention).

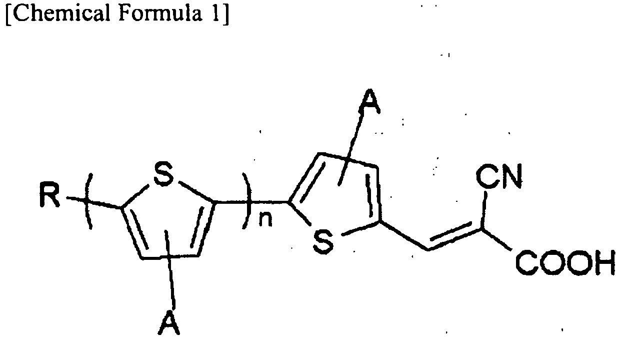

In the formula 1, R, A and n are as defined above.

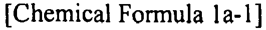

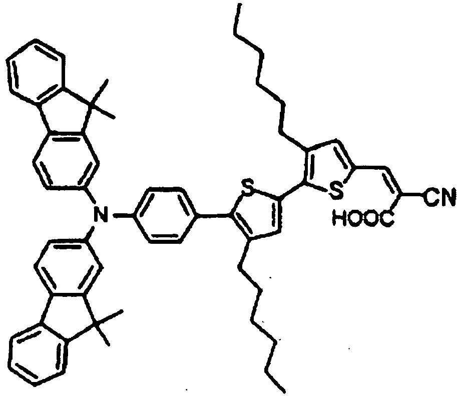

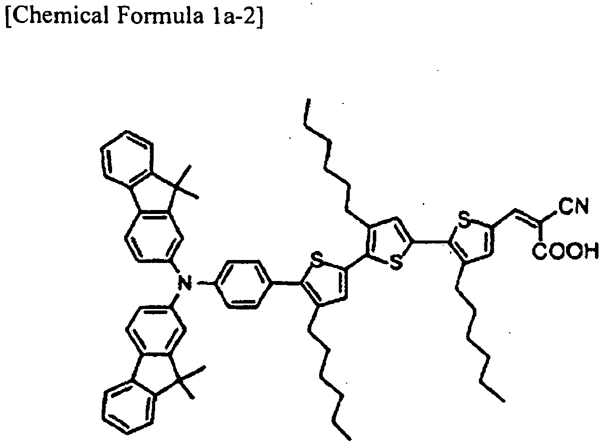

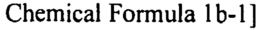

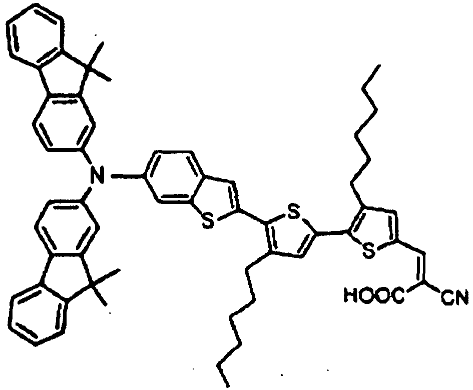

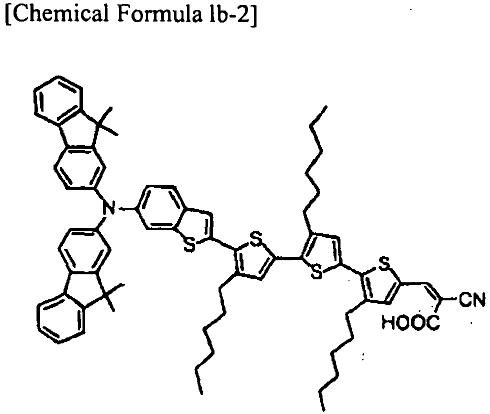

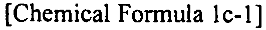

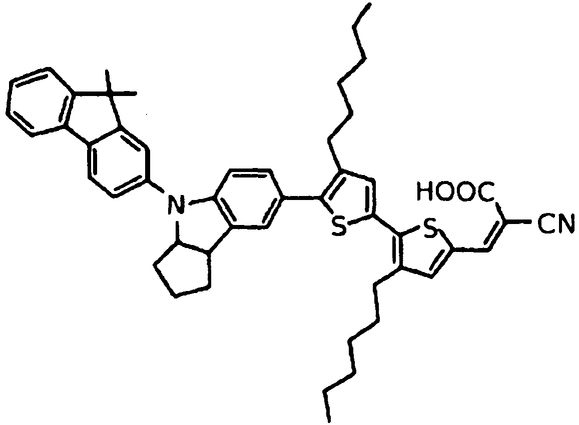

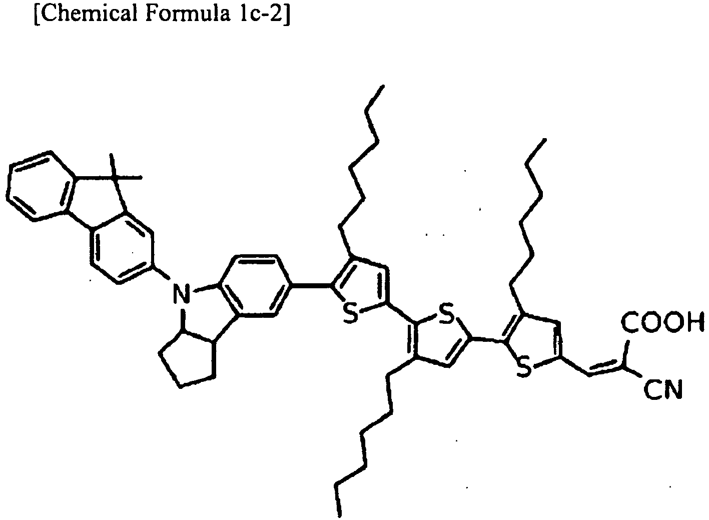

The dye which is represented by the chemical formula 1, from which compounds 1c-1 and 1c-2 are compounds of the present invention, may be made by (1) allowing a compound of the chemical formula 2 to react with a compound of the chemical formula 3 in 1,2-dimethoxyethane to make a compound of the chemical formula 4, (2) allowing the compound of the chemical formula 4 to react with phosphorus oxychloride in dimethylformamide to make a compound of the chemical formula 5 and (3) allowing a compound of the chemical formula 5 to react with cyanoacetate under the presence of piperidine in acetonitrile. The schematic may be a following reaction formula 1.

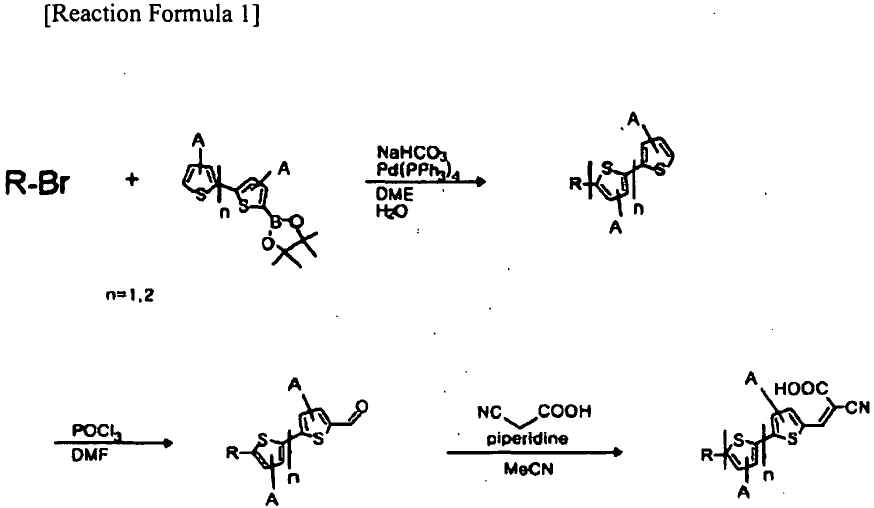

In the formula, R, A and n are as defined above.

The present invention further provides a dye-sensitized photoelectric conversion element, which is characterized by mixing oxide semiconductor particles with a dye represented by the chemical formula 1c-1 and 1c-2. In addition to using the dye represented by the chemical formula 1c-1 and 1c-2, the dye-sensitized photoelectric conversion element for a solar cell according to the present invention may be manufactured by using a conventional dye, and more preferably, by forming a oxide semiconductor layer on a substrate with oxide semiconductor particles and then by dipping the layer into the dye according to the present invention.

In the present invention, the substrate on which the oxide semiconductor layer is formed preferably has a conductive surface. The substrate may be commercial. More specifically, the substrate may be used by forming a conductive metal oxide such as tin oxide applied with indium, fluorine and antimony or a metal layer such as steel, silver and gold on a surface of a glass or on a conductive, high molecular surface such as polyethyleneterephthalate or polyethersulfone. Preferably, conductivity is 1000 Ω and less, and more preferably 100 Ω and less.

Preferably, particles of the oxide semiconductor include metal oxide. More specifically, the metal oxide may include oxide such as titanium, tin, zinc, tungsten, zirconium, gallium, indium, yttrium, niobium, tantalium, vanadium, etc. Preferably, the metal oxide includes titanium, tin, zinc, niobium and indium, more preferably titanium dioxide, zinc oxide, tin oxide, and most preferably titanium oxide. The oxide semiconductor may be used alone, mixed with others or coated on a surface of the semiconductor.

The average diameter of the particles of the oxide semiconductor is preferably 1 to 500nm, and more preferably 1 to 100nm. The particles of the oxide semiconductor may have large and small diameters together or may have multiple layers.

The oxide semiconductor layer may be provided by spraying oxide semiconductor particles directly to a substrate, by electrically extracting a semiconductor particle layer using a substrate as an electrode, by drying, hardening or firing a substrate after applying a paste including slurry of semiconductor particles or particles generated by hydrolyzing precursors of semiconductor particles such as semiconductor alkoxide on the substrate, and preferably by applying the paste on the substrate. In this case, the secondary-coagulated oxide semiconductor particles are dispersed in a dispersion medium by a known method to have an average primary diameter of 1 to 200nm to thereby form the slurry.

The dispersion medium which disperses the slurry may vary as long as it disperses the semiconductor particles. More specifically, the dispersion medium may include water, alcohol such as ethanol, ketone such as acetone, acetyl acetone or hydrocarbon such as hexane, which may be mixed together to be used. Preferably, the dispersion medium includes water since it less changes viscosity of the slurry. A dispersion stabilizer may be used to stabilize a dispersion status of the oxide semiconductor particles. More specifically, the dispersion stabilizer may include e.g., acid such as acetic acid, hydrochloric acid and nitric acid, acetyl acetone, acrylic acid, polyethyleneglycol, polyvinylalcohol and the like.

The substrate which is applied with the slurry may be fired at firing temperatures of 100°C and more, and preferably 200°C and more. The upper limit of the firing temperatures is the melting point (softening point) of the material, i.e., 900°C, and preferably 600°C and less. The firing temperatures according to the present invention are not limited particularly, but preferably within 4 hours.

According to the present invention, a thickness of the layer formed on the substrate may be 1 to 200µm, and preferably 1 to 50µm. If the substrate is fired, some of the oxide semiconductor particles layer are melted and attached, but do not affect the present invention particularly.

The oxide semiconductor layer may be secondary treated. For example, the layer may be applied with a solution of alkoxide, chloride, nitride and sulfide which are the same metal as a semiconductor, and then dried or fired again to improve performance. The metal alkoxide may include titanethoxide, titaniumisoproepoxide, titan t-butoxide, n-dibutyldiacetyl tin and the like, or an alcohol solution thereof. The chloride may include e.g., titanium tetrachloride, tin tetrachloride, zinc chloride and the like, or an aqueous solution thereof. The obtained oxide semiconductor layer includes particles of the oxide semiconductor.

A method of applying the dye to the oxide semiconductor particles layer according to the present invention is not limited to a particular method. More specifically, the substrate having the oxide semiconductor layer may be dipped into a solution which is made by dissolving the dye represented by the chemical formula 1, compounds 1c-1 and 1c-2 thereof being embodiments of the present invention, with a solvent or dipped into a dispersion solution which is made by dispersing the dye. The concentration of the solution or the dispersion solution may be properly determined depending on the dye. The applying temperature ranges from normal temperatures to the boiling point of the solvent. The applying time ranges from one minute to 48 hours. More specifically, the solvent which dissolves the dye may include e.g., methanol, ethanol, acetonitrile, dimethylsulfoxide, dimethylformamide, acetone, t-butanol, etc. The dye concentration of the solution is typically 1X10⁻⁶M to 1M, and preferably 1X10 ₋₅M to 1X10⁻¹M. Thus, the present invention may provide a dye-sensitized photoelectric conversion element which includes a dye-sensitized oxide semiconductor particles layer.

The dye which is represented by the chemical formula 1 may include a single or at least two dyes mixed. If the dyes are mixed, other dyes or metal complex dyes may be mixed together. The metal complex dye to be mixed may include e.g., ruthenium complex or triarylmethylium salt thereof, phthalocyanine, porphyrine, etc. The organic dye to be mixed may include metal-free phthalocyanine, porphyrine, cyanine, merocyanine, oxonol, triphenylmethane, metin dye such as acrylic acid dye disclosed in WO2002/011213, xanthen dye, azo dye, anthraquinone dye, perylene dye and the like (Document: M. K. Nazeeruddin, A. Kay, I. Rodicio, R. Humphry-Baker, E. Muller, P. Liska, N. Vlachopoulos and M. Gratzel, J. Am. Chem. Soc., 1993, vol. 115, p. 6382). If two or more dyes are used, they may sequentially be applied to the semiconductor layer or may be mixed together to be applied to the semiconductor layer.

If the oxide semiconductor particles layer according to the present invention is dipped into the dyes, the layer may be dipped into the dye under the presence of an inclusion compound to prevent the dyes from being bonded to one another. The inclusion compound may include cholic acid such as deoxycholic acid, dehydrodeoxycholic acid, chenodeoxycholic acid, cholic acid methylester, cholic acid natrium and the like, a steroid compound such as polethyleneoxide, cholic acid and the like, crown ether, cyclodextrin, calixarene, polyethyleneoxide, etc.

After being dipped into the dye, the electrode surface of the semiconductor layer may be treated by an amine compound such as 4-t-butyl pyridine or by a compound such as acetic acid, propionic acid which has an acidic group. For example, the substrate which has the semiconductor particles layer carrying the dye may be dipped into an ethanol solution of amine.

Further, the present invention provides a dye-sensitized solar cell which includes the dye-sensitized photoelectric conversion element. The solar cell may be manufactured by a known method by using a conventional photoelectric conversion element as well as using the dye-sensitized photoelectric conversion element having the oxide semiconductor particles layer carrying the dye represented by the chemical formula 1, especially 1c-1 and 1c-2. More specifically, the dye-sensitized solar cell may include an electrode (negative) of a photoelectric conversion element which is formed by applying the dye represented by the chemical formula 1, especially 1c-1 and 1c-2, to the oxide semiconductor particles layer, a counter electrode (positive), a redox electrolyte, a hole transferring material or a p-type semiconductor.

Preferably, the manufacturing method of the dye-sensitized solar cell according to the present invention includes an operation of coating TiO₂ paste on a transparent conductive substrate, an operation of firing the paste-coated substrate to form a TiO₂ layer, an operation of dipping the substrate having the TiO₂ layer to a solution including the dissolved dye represented by the chemical formula 1c-1 and/or 1c-2 to form a TiO₂ film electrode having the dye, an operation of providing a second glass substrate including a counter electrode on the TiO₂ film electrode, an operation of forming a hole to pass through the second glass substrate and the counter electrode, an operation of coupling the counter electrode and the TiO₂ film electrode by heat and pressure, leaving a thermoplastic polymer film therebetween, an operation of injecting an electrolyte to the thermoplastic polymer film interposed between the counter electrode and the TiO₂ film electrode through the hole and an operation of sealing the thermoplastic polymer film.

The redox electrolyte, the hole transferring material and the p-type semiconductor may be liquid, coagulate (gel and gel phase), solid, etc. The redox electrolyte, the hole transferring material and the p-type semiconductor may be liquid by being dissolved by a solvent or may include normal temperature-molten salt. The redox electrolyte, the hole transferring material and the p-type semiconductor may be coagulate (gel and gel phase) by being included in a polymer matrix or a monomer gelation agent. The redox electrolyte, the hole transferring material and the p-type semiconductor may be solid themselves.

The hole transferring material may include an amine derivative, a conductive polymer such as polyacetylene, polyaniline, polythiophene, a material such as a triphenylene compound using a discotheque liquid crystal phase, etc. The p-type semiconductor may include CuI, CuSCN and the like. Preferably, the counter electrode is conductive and acts as a catalyst for a reduction reaction of the redox electrolyte. For example, platinum, carbon, rhodium, ruthenium may be deposited on a glass or a polymer film, or conductive particles may be applied to the glass or the polymer film to form the counter electrode.

The redox electrolyte of the solar cell according to the present invention may include a halogen oxidation reduction electrolyte including a halogen compound having a halogen ion as a counter ion and a halogen molecule, a metal oxidation reduction electrolyte such as ferrocyanide, ferrocene-ferricinium ion or a metal complex such as a cobalt complex, an organic oxidation reduction electrolyte such as alkylthiol-alkyldisulfide, viologen dye and hydroquinone-quinone and the like. Preferably, the redox electrolyte includes a halogen oxidation reduction electrolyte. Preferably, the halogen molecule of the halogen oxidation reduction electrolyte including the halogen compound-halogen molecule includes an iodine molecule. The halogen compound which has a halogen ion as a counter ion may include halogenated metal salt such as LiI, NaI, KI, CaI₂, MgI₂, CuI, halogen organic ammonium salt such as tetraalkylammoniumiodine, imidazoliumiodine, phyridiumiodine, or I₂.

The redox electrolyte may include a solution added with the foregoing materials. In this case, a solvent may electrochemically be inactive. More specifically, the solvent may include e.g., acetonitrile, propylenecarbonate, ethylenecarbonate, 3-methoxypropionitrile, methoxyacetonitrile, ethyleneglycol, propyleneglycol, diethyleneglycol, triethyleneglycol, butylolactone, dimethoxyethane, dimethylcarbonate, 1,3-dioxolane, methylformate, 2-methyltetrahydrofurane, 3-methoxy-oxazolidine-2-on, sulforane, tetrahydrofurane, water and the like. Preferably, the solvent includes acetonitrile, propylenecarbonate, ethylenecarbonate, 3-methoxypropionitrile, ethyleneglycol, 3-methoxy-oxazolidine-2-on, butylolactone, etc. The solvents may be used alone or mixed together to be used. The gel phase positive electrolyte may be formed by adding an electrolyte or an electrolyte solution to a matrix such as oligomer and polymer or by adding an electrolyte or an electrolyte solution to a monomer gelation agent. The concentration of the redox electrolyte may be 0.01 to 99wt%, and more preferably 0.1 to 30wt%.

The solar cell according to the present invention may be manufactured by providing the photoelectric conversion element (negative) having the oxide semiconductor particles carrying the dye and the counter electrode (positive) facing the photoelectric conversion element and by injecting the solution including the redox electrolyte therebetween.

Hereinafter, examplesof the present invention and examples which are not embodiments of the present invention are provided to help understand the present invention.

[Examples]

**[Example 1] Synthesis of dye**

**I) (which is not an embodiment of the present invention) N,N-bis(9,9-dimethylfluorene-2-nyl)-4-(3',4-dihexyl-2,2'-bithiophene-5-yl)aniline (Compound 3, n=1)**

N,N-bis(9,9-dimethylfluorene-2-nyl)-4-bromoaniline (0.302g, 0.542mmol), 2-(3',4-dihexyl-2,2'-bithiophene-5-yl)-4,4,5,5-tetramethyl-1,3,2-dioxaborolane (0.3g, 0.651 mmol) solution (Na²CO³) (2M, 1.626mmol) and tetrakys triphenyl phosphinopalladium (0.031g, 0.027mmol) were mixed for 15 hours at 90°C in 1,2-dimethoxyethane (50ml). After the mixture was cooled, all solvents were removed therefrom. Then, the mixture was divided by a chromatography developer (dichloromethane:hexane = 1:3) to obtain a light yellow title compound.

**II) (which is not an embodiment of the present invention) N,N-bis(9,9-dimethylfluorene-2-nyl)-4-(3',4,3"-trihexyl-2,2' :5',2"-terthiophene-5-yl)aniline (Compound 3, n=2)**

The same process as the operation I) was performed to obtain a light yellow title compound except that N,N-bis(9,9-dimethylfluorene-2-nyl)-4-bromoaniline (0.22g, 0.398mmol),2-(3',4,3"-trihexyl-2,2':5',2"-terthiophene-5-yl)-4,4,5,5-tetramethyl-1,3,2-dioxaborolane (0.3g, 0.478mmol) solution (Na²CO³) (2M, 1.19mmol), tetrakys triphenyl phosphinopalladium (0.023g, 0.0199 mmol) and a chromatography developer (dichloromethane:hexane = 1:5) were used.

**III) (which is not an embodiment of the present invention) N,N-bis(9,9-dimethylfluorene-2-nyl)-4-(3',4-dihexyl-5'-formyl-2,2'-bithiophene-5-yl)aniline (Compound 4, n=1)**

After dimethylformamide (solvent) (20ml) was put to the compound 3 (n=1) (0.8g, 0.987mmol) made at the operation I), phosphorus oxychloride (0.302g, 1.974mmol) was slowly added thereto at 0°C. The mixture was maintained at normal temperatures. After reacting for 30 minutes, the mixture was distilled to remove all solvents. The mixture was divided by a chromatography developer (dichloromethane:hexane = 1:1) to obtain a red solid title compound (yield 65%).

Mp: 194°C. 1H NMR (CDCl₃): δ 9.82 (s, 1H), 7.65-7.59 (m, 4H), 7.49-7.21 (m, 14H), 7.18 (s, 1H), 7.09 (s, 1H), 2,84 (t, J=7.7 Hz, 2H), 2.71 (t, J=7.7 Hz, 2H),1.72-1.58 (m, 4H), 1.43 (s, 12H), 1.40-1.24(m, 12H), 0.93 (t, J=6.6 Hz, 3H), 0.87 (t, J=6.6 Hz, 3H).

**IV) (which is not an embodiment of the present invention) N,N-bis(9,9-dimethylfluorene-2-nyl)-4-(3',4,3"-trihexyl-5"-formyl-2,2':5',2"-terthi ophene-5-yl)aniline (Compound 4, n=2)**

The same process as the operation III) was performed to obtain a red solid title compound (yield 70%) except that the compound 3 (n=2) (0.2g, 0.204mmol) made at the operation II), phosphorus oxychloride (0.062g, 0.408mmol) and a chromatography developer (ethylacetate:hexane = 1:10) were used. (yield 70%).

Mp: 198°C. 1H NMR (CDCl₃): δ 9.82 (s, 1H), 7.64-7.59 (m, 4H), 7.38-7.19 (m, 14H), 7.16 (s, 1H), 7.12 (s, 1H), 7.04 (s, 1H), 2,82-2.74 (m, 4H), 2.70 (t, J=7.7 Hz, 2H),1.68-1.51 (m, 6H), 1.42 (s, 12H), 1.38-1.14(m, 18H), 0.88 (t, J=6.6 Hz, 6H), 0.79 (t, J=6.6 Hz, 3H).

**V) JK-48 (Chemical Formula 1a-1, n=1) (which is not an embodiment of the present invention)**

After cyanoacetic acid (0.047g, 0.548mmol) and acetonitrile (solvent) (30ml) were put to the compound 4 (n=1) made at the operation III), piperidine (0.023g, 0.274mmol) was added thereto. The mixture was heated for 12 hours and then all solvents were removed therefrom. The mixture was dissolved in dichloromethane and cleansed by water. After extracting only dichloromethane organic solvent, the mixture was dried by a drier, magnesium sulphate (MgSO₄). Chromatography (EA:HX =1:1, Methanol) was used to obtain a pure title compound (yield 54%).

Mp: 210°C. 1H NMR (DMSO *d₆*):δ 8.14 (s, 1H), 7.68-7.59 (in, 4H), 7.49-7.21 (m, 15H), 7.20 (s, 1H), 2,89 (t, J=7.7 Hz, 2H), 2.74 (t, J=7.7 Hz, 2H), 1.74-1.56 (m, 4H), 1.42 (s, 12H), 1.39-1.24(m, 12H), 0.92 (t, J=6.6 Hz, 3H), 0.88 (t, J=6.6 Hz, 3H).

**VI) JK-45 (Compound 1a-2, n=2) (which is not an embodiment of the present invention)**

The same process as the operation V was performed to obtain a pure title compound (yield 56%) except that the compound 4 (n=2) (0.12g, 0.119mmol) made at the operation IV), cyanoacetic acid (0.020g, 0.238mmol) and piperidine (0.01 g, 0.119mmol) were used. (yield 56%).

Mp: 198°C. 1H NMR (CDCl₃): δ 8.17 (s, 1H), 7.83-7.67 (m, 4H),7.40 (s, 1H), 7.38-7.24 (m, 15H), 7.21 (s, 1H), 2,82-2.74 (m, 4H), 2.70 (br, 2H),1.72-1.54 (in, 6H), 1.42 (s, 12H), 1.38-1.14(m, 18H), 0.88 (m, 6H), 0.80 (t, J=6.6 Hz, 3H).

**VII) 6-(bis(9,9-dimethylfluorene-2-yl)amino)-2-(3',4-dihexyl-2,2'-bithiophene-5-yl)benz o[bi]thiophene (Compound 5, n=1)(which is not an embodiment of the present invention)**

The same process as the operation I) was performed to obtain a light yellow solid title compound except that 6-(bis 9,9-dimethylfluorene-2-yl)amino)-2-bromobenzo [bi]thiophene (0.332g, 0.543 mmol) was used.

**VIII) (which is not an embodiment of the present invention) 6-(bis(9,9-dimethylfluorene-2-yl)amino)-2-(3',4,3"-trihexyl-2,2':5',2"-terthiophene -5-yl)benzo[bi]thiophene (Compound 5, n=2)**

The same process as the operation I) was performed to obtain a light yellow solid title compound except that 6-(bis 9,9-dimethylfluorene-2-yl)amino)-2-bromobenzo[bi]thiophene (0.24g, 0.398mmol) and a chromatography developer (dichloromethane:hexane = 1:5) were used.

**IX) (which is not an embodiment of the present invention) 6-(bis(9,9-dimethylfluorene-2-yl)amino)-2-(3',4-dihexyl-5-formyl-2,2'-bithiophene -5-yl)benzo[bilthiophene (Compound 6, n=1)**

The same process as the operation III) was performed to obtain a red solid title compound (yield 62%) except that the compound 5 (n=1) (0.4g, 0.461mmol) made at the operation VII) and phosphorus oxychloride (0.141g, 0.923mmol) were used. (yield 62%).

Mp: 192°C. 1H NMR (CDCl₃): δ 10.01 (s, 1H), 7.66-7.57 (in, 3H), 7.40-7.24 (in, 13H), 7.14-7.10 (m, 2H), 7.02 (s, 1H), 6.97 (s, 1H), 6.93 (s, 1H), 2,94 (t, J=7.7 Hz, 2H), 2.81 (t, J=7.7 Hz, 2H), 1.69-1.65 (m, 4H), 1.41 (s, 12H), 1.40-1.24(m, 12H), 0.89 (m, 6H).

**X) (which is not an embodiment of the present invention) 6-(bis(9,9-dimethylfluorene-2-yl)amino)-2-(3',4,3"-trihexyl-5"-formyl-2,2':5';2"-terthiophene-5-yl)benzo[bi]thiophene (Compound 6, n=2)**

The same process as the operation III) was performed to obtain a red solid title compound (yield 70%) except that the compound 5 (n=2) made at the operation
VIII), phosphorus oxychloride (0.074g, 0.484mmol) and a chromatography developer (ethylacetate:hexane = 1:10) were used. (yield 70%).

Mp: 198°C. 1H NMR (CDCl₃): δ 9.82 (s, 1H), 7.68-7.59 (m, 3H), 7.40-7.25 (m, 13H), 7.12-7.09 (m, 2H), 7.05 (s, 1H), 7.02 (s, 1H), 7.00 (s, 1H), 2,82-2.78 (m, 6H), 1.69-1.58 (m, 6H), 1.41 (s, 12H), 1.38-1.14(m, 18H), 0.88 (t, J=6.6 Hz, 6H), 0.82 (br, 3H).

**XI) JK-49 (Compound 1b-1, n=1) (which is not an embodiment of the present invention)**

The same process as the operation V) was performed to obtain a pure title compound (yield 56%) except that the compound 6 (n=1) (0.1g, 0.111mmol) made at the operation IX, cyanoacetic acid (0.019g, 0.223mmol) and piperidine (0.009g, 0.111mmol) were used. (yield 56%).

Mp: 198°C. 1H NMR (CDCl₃): δ 8.23 (s, 1H), 7.88-7.72 (m, 3H), 7.60-7.47 (m, 14H), 7.42 (s, 1H), 7.27-7.22 (m, 2H), 7.14 (s, 1H), 2,91 (t, J=7.7 Hz, 2H), 2.79 (t, J=7.7 Hz, 2H),1.69-1.65 (m, 4H), 1.41 (s, 12H), 1.40-1.24(m, 12H), 0.89 (m, 6H).

**XII) JK-46 (Compound 1b-2, n=2) (which is not an embodiment of the present invention)**

The same process as the operation V) was performed to obtain a pure title compound (yield 59%) except that the compound 6 (n=2) (0.13g, 0.123mmol) made at the operation X), cyanoacetic acid (0.020g, 0.245mmol) and piperidine (0.01g, 0.122mmol) were used. (yield 59%).

Mp: 193°C. 1H NMR (CDCl₃): δ 8.26 (s, 1H), 7.89-7.74 (m, 3H), 7.60-7.45 (m, 14H), 7.39 (s, 1H), 7.28-7.19 (m, 3H), 2,82-2.78 (m, 6H), 1.69-1.58 (m, 6H), 1.41 (s, 12H), 1.38-1.14(m. 18H), 0.88 (t, J=6.6 Hz, 6H), 0.82 (br, 3H).

**XIII) (which is not an embodiment of the present invention) 4-(9,9-dimethylfluorene-2-yl)-7-(3',4-dihexyl-2,2'-bithiophene-5-yl)-1,2,3,3a,4,8b-hexahydrocyclopenta[b]indole (Compound 7, n=1)**

The same process as the operation I) was performed to obtain a light yellow solid title compound except that 4-(9,9-dimethylfluorene-2-yl)-1,2,3,3a,4,8b-hexahydrocyclopenta[bi]indole (0.336g, 0.781mmol),2-(3',4-dihexyl-2,2'-bithiophene-5-yl)-4,4,5,5-tetramethyl-1,3,2-dioxaborolane (0.54a, 1.172mmol) solution (Na²CO³) (2M, 2.343mmol) and tetrakys triphenyl phosphinopalladium (0.045g, 0.027mmol) were used.

**XIV) (which is not an embodiment of the present invention) 4-(9,9-dimethylfluorene-2-yl)-7-(3',4,3"-trihexyl-2,2':5',2"-terthiophene-5-yl)-1,2, 3,3a,4,8b-hexahydrocyclopenta[bi]indole (Compound 7, n=2)**

The same process as the operation I) was performed to obtain a light yellow solid title compound except that 4-(9,9-dimethylfluorene-2-yl)-1,2,3,3a,4,8b-hexahydrocyclopenta[bi]indole (0.228g, 0.531 mmol), 2-(3',4,3"-trihexyl-2,2':5',2"-terthiophene-5-yl)-4,4,5,5-tetramethyl-l,3,2-dioxaborolane (0.4g, 0.638mmol) solution (Na²CO³) (2M, 1.59mmol), tetrakys triphenyl phosphinopalladium (0.03, 0.0265mmol) and a chromatography developer (dichloromethane:hexane = 1:5) were used.

**XV) (which is not an embodiment of the present invention) 4-(9,9-dimethylfluorene-2-yl)-7-(3',4-dihexyl-5-formyl-2,2'-bithiophene-5-yl)-1,2, 3,3a,4,8b-hexahydrocyclopenta[bi]indole (Compound 8, n=1)**

The same process as the operation III) was performed to obtain a red solid title compound (yield 57%) except that the compound 7 (n=1) (0.22g, 0.321mmol) made at the operation XIII) and phosphorus oxychloride (0.098g, 0.643mmol) were used. (yield 57%).

Mp: 189°C. 1H NMR (CDCl₃): δ 9.82 (s, 1H), 7.67-7.63 (m, 3H), 7.41-7.22 (m, 7H),7.14 (s, 1H), 7.02 (s, 1H), 4.82 (t, J= 6.0 Hz, 1H), 3.87 (t, J= 6.0 Hz, 1H), 2,94 (t, J=7.7 Hz, 2H), 2.81 (t, J=7.7 Hz, 2H),2.11-1.95(m, 4H), 1.85-1.70(m, 2H), 1.69-1.65 (m, 4H), 1.41 (s, 12H), 1.40-1.24(m, 12H), 0.89 (m, 6H).

**XVI) (which is not an embodiment of the present invention) 4-(9,9-dimethylfluorene-2-yl)-7-(3',4,3"-trihexyl-5"-formyl-2,2':5',2"-terthiophen e-5-yl)-1,2,3,3a,4,8b-hexahydrocyclopenta[bi]indole (Compound 8, n=2)**

The same process as the operation III) was performed to obtain a red solid title compound (yield 59%) except that the compound 7 (n=2) (0.54g, 0.635mmol) made at the operation XIV), phosphorus oxychloride (0.194g, 1.27mmol) and a chromatography developer (ethylacetate:hexane = 1:10) were used. (yield 59%).

Mp: 191°C.1H NMR (CDCl₃): δ 9.83 (s, 1H), 7.67-7.63 (m, 3H), 7.41-7.22 (m, 7H), 7.14 (s, 1H), 7.09 (s, 1H), 7.04 (s, 1H), 4.82 (t, J= 6.0 Hz, 1H), 3.87 (t, J= 6.0 Hz, 1H), 2,82-2.78 (m, 6H), 2.11-1.95(m, 4H), 1.85-1.70(m, 2H), 1.69-1.58 (m, 6H), 1.41 (s, 12H), 1.38-1.14(m, 18H), 0.88 (t, J=6.6 Hz, 6H), 0.82 (br, 3H).

**XVII) JK-50 (Compound 1c-1, n=1)**

The same process as the operation V) was performed to obtain a pure title compound (yield 56%) except that the compound 8 (n=1) (0.2g, 0.28mmol) made at the operation XV) was used. (yield 56%).

Mp: 187°C.1H NMR (CDCl₃): δ 8.27 (s, 1H), 7.87-7.78 (m, 3H), 7.61-7.42 (m, 7H),7.41 (s, 1H), 7.22 (s, 1H), 4.82 (t, J= 6.0 Hz, 1H), 3.87 (t, J= 6.0 Hz, 1H), 2,94 (t, J=7.7 Hz, 2H), 2.81 (t, J=7.7 Hz, 2H),2.11-1.95(m, 4H), 1.85-1.70(m, 2H), 1.69-1.65 (m, 4H), 1.41 (s, 12H), 1.40-1.24(m, 12H), 0.89 (m, 6H).

**I) JK-47 (Compound 1c-2, n=2)**

The same process as the operation V) was performed to obtain a pure title compound (yield 53%) except that the compound 8 (n=2) (0.2g, 0.228mmol) made at the operation XVI), cyanoacetic acid (0.038g, 0.455mmol) and piperidine (0.019g, 0.228mmol) were used. (yield 53%).

Mp: 189°C.1H NMR (CDCl₃): δ 8.17 (s, 1H), 7.79-7.63 (m, 3H), 7.61-7.52 (m, 8H), 7.44 (s, 1H), 7.39 (s, 1H), 4.82 (t, 3= 6.0 Hz, 1H), 3.87 (t, J= 6.0 Hz, 1H), 2,82-2.78 (m, 6H), 2.11-1.95(m, 4H), 1.85-1.70(m, 2H), 1.69-1.58 (m, 6H), 1.41 (s, 12H), 1.38-1.14(m, 18H), 0.88 (t, J=6.6 Hz, 6H), 0.82 (br, 3H).

[**Example 2] Fabrication of dye-sensitized solar cell**

To evaluate current-voltage properties of a dye compound, a solar cell was fabricated by using a transparent layer of 20+4µm TiO₂. TiO₂ paste (Solaronix, 13nm anatase) was screen-printed to form a first TiO₂ layer as an electrode, in 20µm thickness while a second TiO₂ scattering layer of 4µm was formed by using another paste (CCIC, HWP-400) for light scattering. The dye compounds la-1, la-2, 1b-1, 1b-2 (which are not embodiments according to the present invention), 1c-1 and 1c-2 according to the present invention made at the operations IV), V), XI), XII), XVII) and XVIII) in the exemplary embodiment 1 were applied to the TiO₂ electrode to manufacture a solar cell. The electrolyte was used by mixing 0.6M 1-hexyl-2,3-dimethylimidazolium iodide, 0.05M iodine, 0.1 M lithium iodiode, 0.5M tertiary-butylpyridine with an acetonitrile solvent.

**[Example 3] Measurement of properties of dye-sensitized solar cell**

The photoelectrochemical characteristics of the solar cell manufactured by using the dye compounds 1a-1, la-2, 1b-1, 1b-2(which are not embodiments according to the present invention), 1c-1 and 1c-2 according to the present invention made at the operations IV), V), XI), XII), XVII) and XVIII) was measured to be shown in a following Table 1. The photoelectrochemical characteristics of the solar cell were measured by a Keithley M236 source measuring device. A light source included a 300W Xe lamp equipped with an AM 1.5 filter (Oriel). The size of the electrode is 0.4 X 0.4cm² and the intensity of light was 1 sun (100mW/cm²). The intensity of the light was adjusted by an Si solar cell.

Table 1

**[Table 1]**

| [Table] | | | | |
|---|---|---|---|---|
| Dye | J_{sc}(mA/cm²) | V_{oc}(V) | F.F | η |
| 1 a-2 | 16.13 | 0.641 | 71.8 | 7.42 |
| 1 b-1 | 11.26 | 0.579 | 74.7 | 4.87 |
| 1 b-2 | 17.45 | 0.664 | 74.2 | 8.60 |
| 1c-1 | 6.25 | 0.553 | 76.1 | 2.63 |
| 1 c-2 | 12.05 | 0.648 | 76.5 | 5.98 |
| N719 | 18.39 | 0.741 | 76.5 | 10.42 |

In Table 1, N719 includes a Ruthenium catalyst used for a conventional dye-sensitized solar cell, and has a following structure.

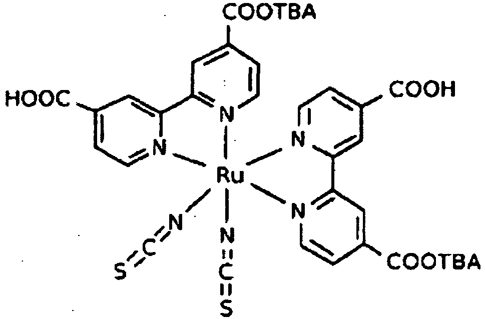

The photoelectrochemical characteristics of the solar cell manufactured by adding 10mM DCA to each of the dye compounds 1a-1, la-2, 1b-1, 1b-2, 1c-1 and 1c-2 made at the operations IV), V), XI), XII), XVII) and XVIII) was measured to be shown in Table 2.

Table2

**[Table2]**

| [Table] | | | | |
|---|---|---|---|---|
| Dye | J_{SC} (mA/c²) | V_{OC} (V) | F.F | η |
| 1a-1 | 8.27 | 0.687 | 80.5 | 4.57 |
| 1a-2 | 10.94 | 0.660 | 76.1 | 5.49 |
| 1b-1 | 6.42 | 0.610 | 77.5 | 3.03 |
| 1b-2 | 12.45 | 0.669 | 77.0 | 6.41 |
| 1c-1 | 3.91 | 0.575 | 79.3 | 1.78 |
| 1c-2 | 7.59 | 0.638 | 78.5 | 3.80 |

In Tables 1 and 2, J_{SC} refers to a short-circuit photocurrent density, Voc is an open circuit photovoltage, ff is a fill factor and η is a total photoelectric conversion efficiency.

As shown in Tables 1 and 2, the dye compounds according to the present invention have characteristics of a good solar cell dye, and have higher values of J_{SC}, Voc, ff and η if not added with DCA than added with DCA. The compound 1b-2 has a higher J_{SC} value, similar to N719. Also, the total conversion efficiency of the dye compounds was high.

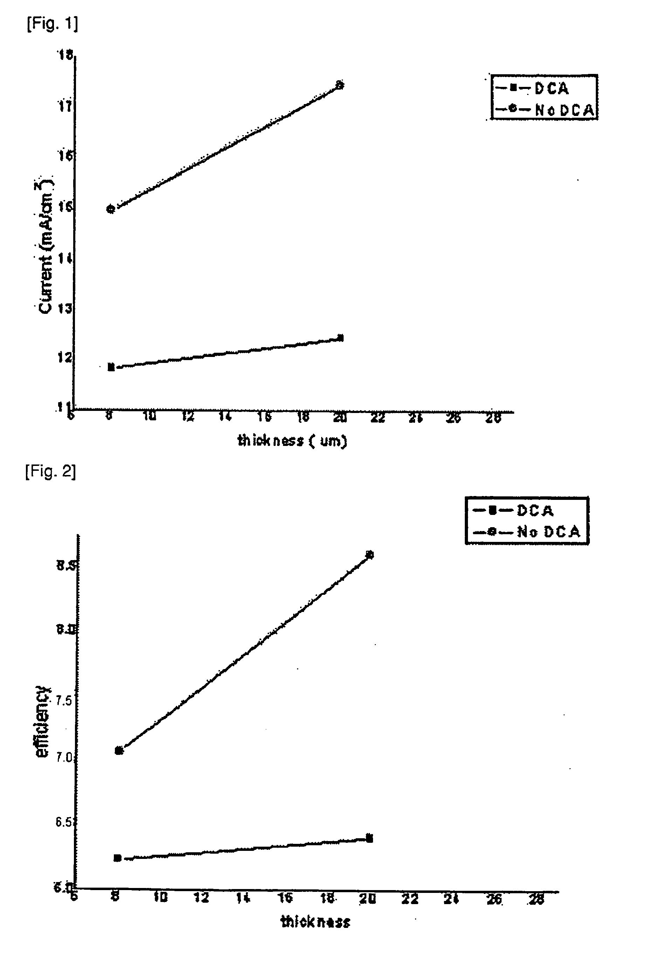

FIGS. 1 and 2 illustrate current (J_{SC}) and photoelectric conversion efficiency (η) for thicknesses of 8µm and 20µm in 20nm TiO₂ when DCA is added and is not added to the compound 1b-2 having the highest J_{SC} value. As shown therein, the compound 1b-2 not using the additive DCA has better current (J_{SC}) and photoelectric conversion efficiency (η) than that using the DCA.

Although a few exemplary embodiments of the present invention have been shown and described, it will be appreciated by those skilled in the art that changes may be made in these exemplary embodiments without departing from the principles and spirit of the invention, the scope of which is defined in the appended claims and their equivalents.

### Industrial Applicability

An organic dye according to the present invention provides better molar extinction coefficient, J_{sc} (short-circuit photocurrent density) and photoelectric conversion efficiency than a conventional metal complex dye to sharply improve efficiency of a solar cell, has a high current and better photoelectric conversion efficiency than an existing organic dye by preventing π-π stacking even without an additive.

## Claims

1. An organic dye, wherein the dye is represented by following chemical formula 1c-1 or 1c-2,

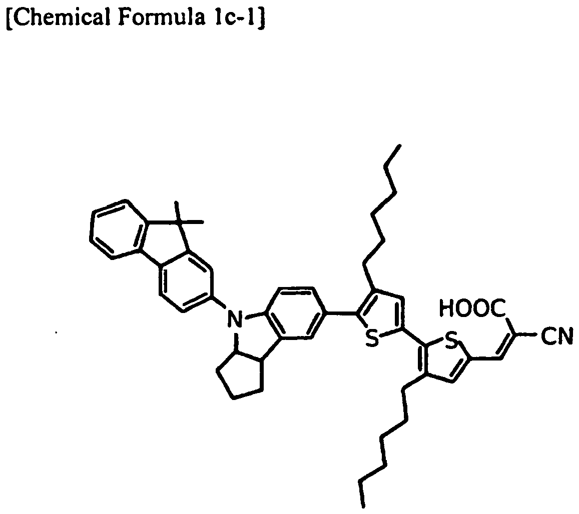

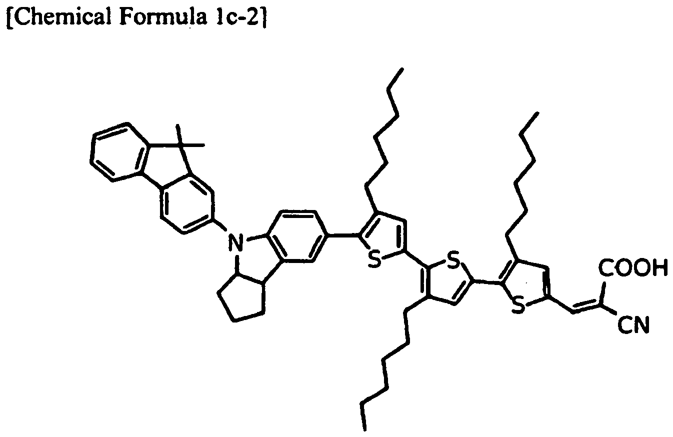

2. A making method of an organic dye which is represented by the chemical formula 1c-1 or 1c-2 "according to claim 1", the making method comprising:
allowing a compound of a following chemical formula 2 to react with a compound of a chemical formula 3 in 1,2-dimethoxyethane to make a compound of a chemical formula 4 below;
allowing the compound of the chemical formula 4 to react with phosphorus oxychloride in dimethylformamide to make a compound of a chemical formula 5 below; and
allowing a compound of a chemical formula 5 to react with cyanoacetate under a presence of piperidine in acetonitrile,
[Chemical Formula 2] **R-Br** 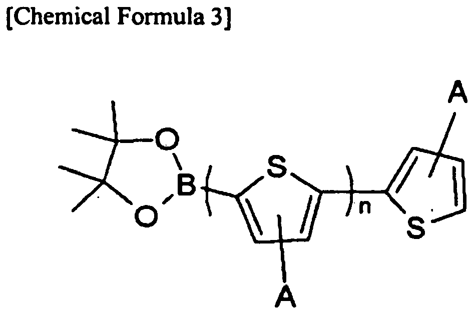 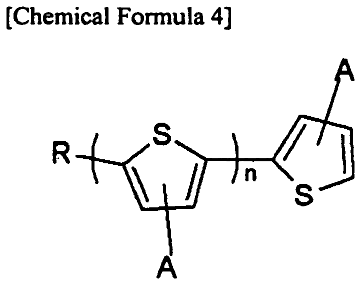 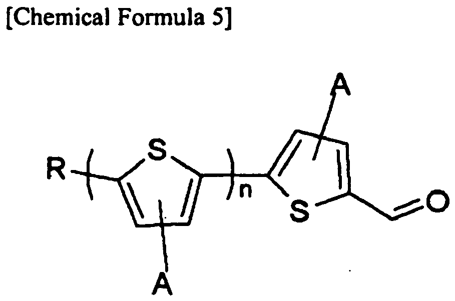
wherein, R refers to 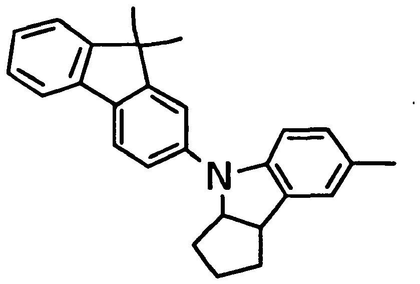 , A is alkyl of C₆ and n is a positive number of 1 or 2.

3. A dye-sensitized photoelectric conversion element which comprises oxide semiconductor particles carrying the organic dye according to claim 1.

4. The dye- sensitized photoelectric conversion element according to claim 3, wherein the oxide semiconductor particles are dipped into the organic dye under a presence of an inclusion compound.

5. The dye- sensitized photoelectric conversion element according to claim 3, wherein the oxide semiconductor particles comprise titanium dioxide as an essential component.

6. The dye- sensitized photoelectric conversion element according to claim 3, wherein an average diameter of the oxide semiconductor particles ranges from 1 to 500nm.

7. A dye-sensitized solar cell which comprises the dye-sensitized photoelectric conversion element according to claim 3 as an electrode.

8. The dye- sensitized solar cell according to claim 7, wherein the dye-sensitized solar cell is manufactured by coating TiO₂ paste on a transparent conductive substrate, firing the paste-coated substrate to form a TiO₂ layer, dipping the substrate having the TiO₂ layer to a solution including the dissolved dye represented by a chemical formula 1c-1 or 1c-2 "according to claim 1" to form a TiO₂ film electrode having the dye, providing a second glass substrate having a counter electrode on the TiO₂ film electrode, forming a hole to pass through the second glass substrate and the counter electrode, coupling the counter electrode and the TiO₂ film electrode by heat and pressure, leaving a thermoplastic polymer film therebetween, injecting an electrolyte to the thermoplastic polymer film interposed between the counter electrode and the TiO₂ film electrode through the hole and sealing the thermoplastic polymer film.

## Patentansprüche

1. Organischer Farbstoff, wobei der Farbstoff durch folgende chemische Formel 1c-1 oder 1c-2 dargestellt ist

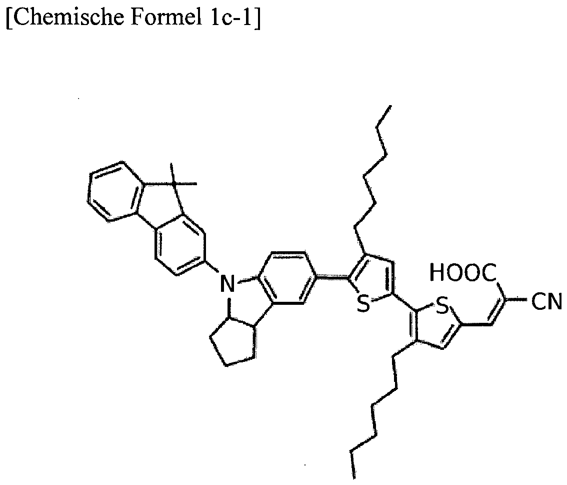

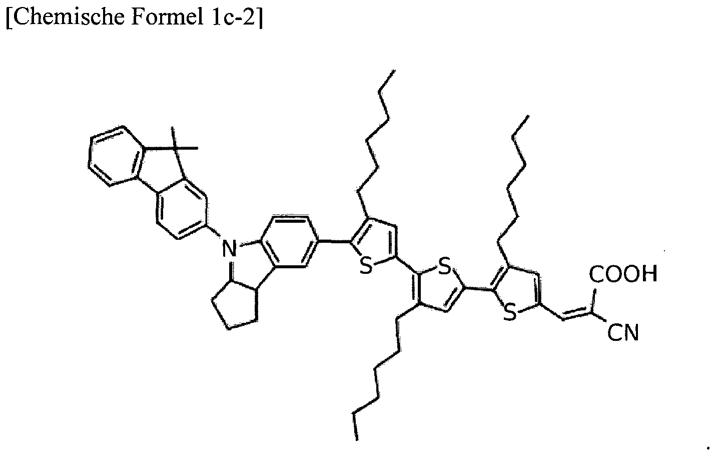

2. Herstellungsverfahren für einen organischen Farbstoff, der durch die chemische Formel 1c-1 oder 1c-2 gemäß Anspruch 1 dargestellt ist, wobei das Herstellungsverfahren aufweist:
Reagieren lassen einer Verbindung einer folgenden chemischen Formel 2 mit einer Verbindung einer chemischen Formel 3 in 1,2-Dimethoxyethan, um eine Verbindung einer nachstehenden chemischen Formel 4 herzustellen;
Reagieren lassen der Verbindung der chemischen Formel 4 mit Phosphoroxychlorid in Dimethylformamid, um eine Verbindung einer nachstehenden chemischen Formel 5 herzustellen; und
Reagieren lassen einer Verbindung einer chemischen Formel 5 mit Cyanoacetat in Gegenwart von Piperidin in Acetonitril,
[Chemische Formel 2] **R-Br** 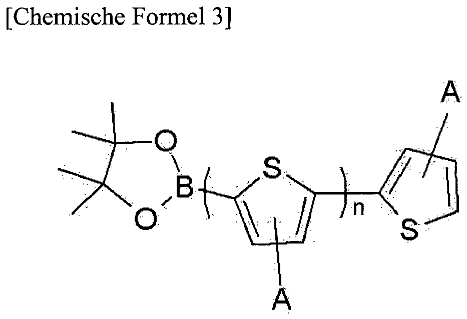 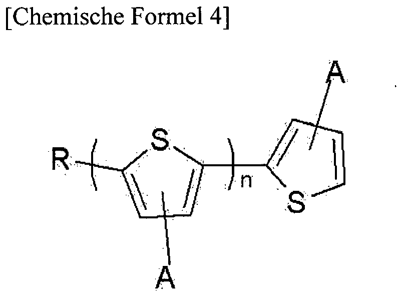 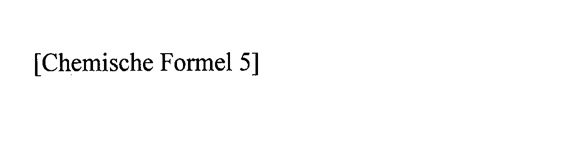 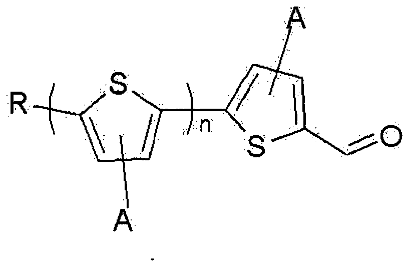
wobei R 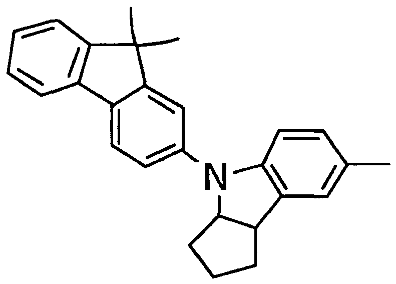 entspricht, A alkyl mit C₆ ist und n eine positive Zahl von 1 oder 2 ist.

3. Farbstoffsensibilisiertes photovoltaisches Umwandlungselement, das Oxid-Halbleiter-Partikel aufweist, die den organischen Farbstoff nach Anspruch 1 tragen.

4. Farbstoffsensibilisiertes photovoltaisches Umwandlungselement gemäß Anspruch 3, wobei die Oxid-Halbleiter-Partikel in den organischen Farbstoff in Gegenwart einer Einschlussverbindung getaucht werden.

5. Farbstoffsensibilisiertes photovoltaisches Umwandlungselement gemäß Anspruch 3, wobei die Oxid-Halbleiter-Partikel Titandioxid als eine wesentliche Komponente aufweisen.

6. Farbstoffsensibilisiertes photovoltaisches Umwandlungselement gemäß Anspruch 3, wobei ein durchschnittlicher Durchmesser der Oxid-Halbleiter-Partikel von 1 bis 500nm reicht.

7. Farbstoffsensibilisierte photovoltaische Solarzelle, die das farbstoffsensibilisierte photovoltaische Umwandlungselement gemäß Anspruch 3 als eine Elektrode aufweist.

8. Farbstoffsensibilisierte photovoltaische Solarzelle gemäß Anspruch 7, wobei die farbstoffsensibilisierte Solarzelle hergestellt wird durch Auftragen einer TiO₂-Paste auf ein transparentes leitfähiges Substrat, Feuern des Pasten-beschichteten Substrats zur Bildung einer TiO₂-Schicht, Tauchen des Substrats mit der TiO₂-Schicht in eine Lösung, die den durch eine chemische Formel 1c-1 oder 1c-2 dargestellten gelösten Farbstoff gemäß Anspruch 1 enthält, um eine TiO₂-Filmelektrode mit dem Farbstoff zu bilden, Bereitstellen eines zweiten Glassubstrats mit einer Gegenelektrode auf der TiO₂-Filmelektrode, Bilden eines Lochs zum Verlaufen durch das zweite Glassubstrat und die Gegenelektrode, Verbinden der Gegenelektrode und der TiO₂-Filmelektrode durch Wärme und Druck, Hinterlassen eines thermoplastischen Polymerfilms dazwischen, Spritzen eines Elektrolyts auf den thermoplastischen Polymerfilm, der zwischen der Gegenelektrode und TiO₂-Filmelektrode liegt, durch das Loch und Abdichten des thermoplastischen Polymerfilms.

## Revendications

1. Colorant organique, dans lequel le colorant est représenté par la formule chimique 1c-1 ou 1c-2 suivante,

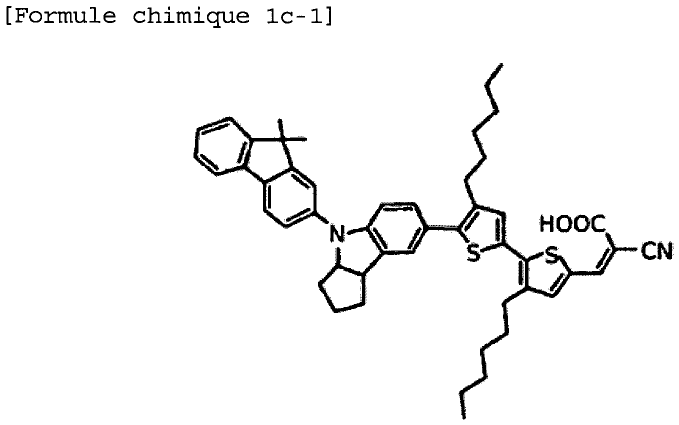

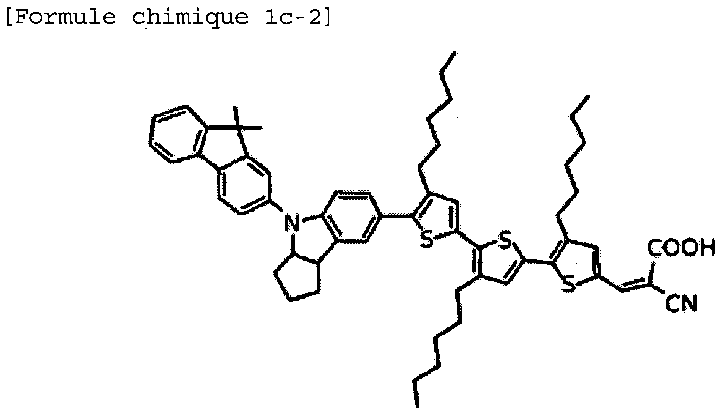

2. Procédé de fabrication d'un colorant organique qui est représenté par la formule chimique 1c-1 ou 1c-2 selon la revendication 1, le procédé de fabrication comprenant les étapes consistant à :
laisser un composé de formule chimique 2 suivante réagir avec un composé de formule chimique 3 dans du 1,2-diméthoxyéthane pour fabriquer un composé de formule chimique 4 ci-dessous ;
laisser le composé de formule chimique 4 réagir avec un oxychlorure de phosphore dans du diméthylformamide afin de fabriquer un composé de formule chimique 5 ci-dessous ; et
laisser un composé de formule chimique 5 réagir avec du cyanoacétate en présence de pipéridine dans l'acétonitrile,
[Formule chimique 2] **R-Br** 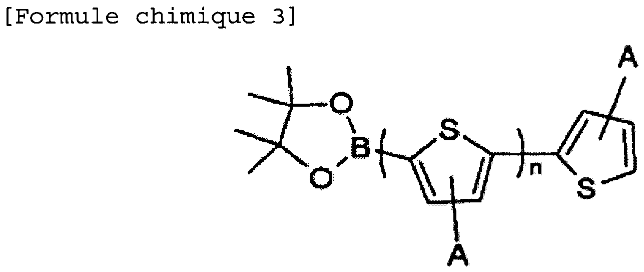 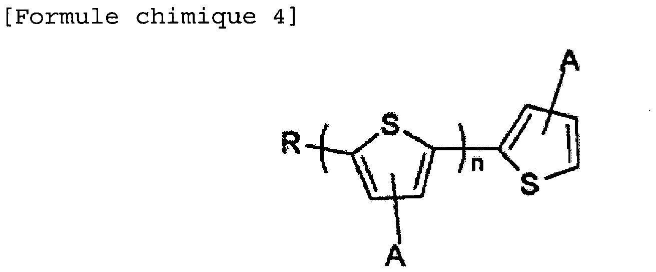 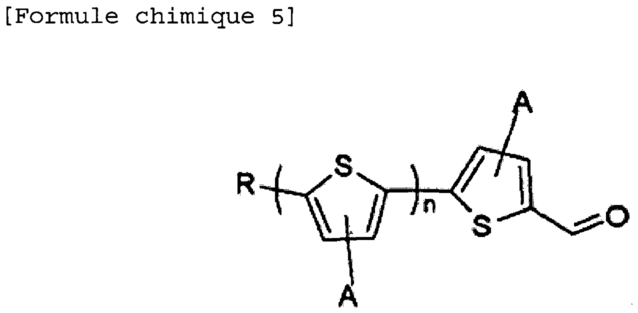
dans laquelle, R se réfère à
, A est alkyle en C₆ et n est un nombre positif de 1 ou 2.

3. Elément de conversion photoélectrique sensible à un colorant qui comprend des particules de semi-conducteur à oxyde portant le colorant organique selon la revendication 1.

4. Elément de conversion photoélectrique sensible à un colorant selon la revendication 3, dans lequel les particules à semi-conducteur à oxyde sont trempées dans le colorant organique en présence d'un composé d'inclusion.

5. Elément de conversion photoélectrique sensible à un colorant selon la revendication 3, dans lequel les particules de semi-conducteur à oxyde comprennent du dioxyde de titane comme composant essentiel.

6. Elément de conversion photoélectrique sensible à un colorant selon la revendication 3, dans lequel un diamètre moyen des particules de semi-conducteur à oxyde va de 1 à 500 nm.

7. Cellule solaire sensible à un colorant qui comprend l'élément de conversion photoélectrique sensible au colorant selon la revendication 3 comme électrode.

8. Cellule solaire sensible au colorant selon la revendication 7, dans laquelle la cellule solaire sensible au colorant est fabriquée par revêtement d'une pâte de TiO₂ sur un substrat conducteur transparent, cuisson du substrat revêtu de pâte afin de former une couche de TiO₂, trempage du substrat ayant la couche de TiO₂ dans une solution comportant le colorant dissous représenté par une formule chimique 1c-1 ou 1c-2 selon la revendication 1 afin de former une électrode à film de TiO₂ ayant le colorant, fourniture d'un second substrat de verre ayant une contre-électrode sur l'électrode à film de TiO₂ formation d'un trou pour passer à travers le second substrat de verre et la contre-électrode, couplage de la contre-électrode et de l'électrode à film de TiO₂ par chaleur et pression, laissant un film polymère thermoplastique entre elles, injection d'un électrolyte dans le film polymère thermoplastique interposé entre la contre-électrode et l'électrode à film de TiO₂ à travers le trou et scellage du film polymère thermoplastique.
